# EUROPEAN PATENT APPLICATION

(11) **EP 2 444 521 A1**
(43) Date of publication of application: **25.04.2012**
(21) Application number: 10789345.5
(22) Date of filing: 24.05.2010
(51) Int. Cl.: C23C 16/44, B01J 3/02, H01L 21/3065

(54) **GAS DISCHARGE STRUCTURE, AND DEVICE AND METHOD FOR PLASMA PROCESSING**

(30) Priority: 18.06.2009 JP 2009145196
(71) Applicant: Mitsubishi Heavy Industries, Ltd., Tokyo 108-8215 (JP)
(72) Inventor: MATSUDA Ryuichi, Tokyo 108-8215 (JP); YOSHIDA Kazuto, Tokyo 108-8215 (JP)
(74) Representative: Wiedemann, Peter
(86) International application number: PCT/JP2010/058733
(87) International publication number: WO 2010/146970

(57) **Abstract**

A gas discharge structure, and a device and a method for plasma processing which are capable of a uniform gas discharge and have improved maintainability. A pendulum gate valve (15) is eccentrically mounted to a vacuum chamber (11) in such a manner that the center (Mc) of the area of an opening region (M) corresponding to the center value of the recommended value for the use of the opening ratio of the pendulum gate valve (15) coincides with the axis center (Cc) of the vacuum chamber (11).

## Description

### TECHNICAL FIELD

The present invention relates to a gas exhaust structure (gas discharge structure) for evacuating gas inside a vacuum chamber, and to an apparatus (a device) and a method for plasma processing.

### BACKGROUND ART

The following processing apparatus is known as a conventional art (Patent Documents 1, 2). In the processing apparatus, a gas exhaust port is provided in a bottom portion of a vacuum chamber, and a vacuum pump such as a turbo molecular pump is provided directly below the gas exhaust port, so that the atmosphere inside the vacuum chamber is evacuated uniformly and thus uniformity in processing is improved.
Patent Document 1: Japanese Patent Application Publication No. Hei 9-167762
Patent Document 2: Japanese Patent Application Publication No. 2002-208584

### DISCLOSURE OF THE INVENTION

### PROBLEMS TO BE SOLVED BY THE INVENTION

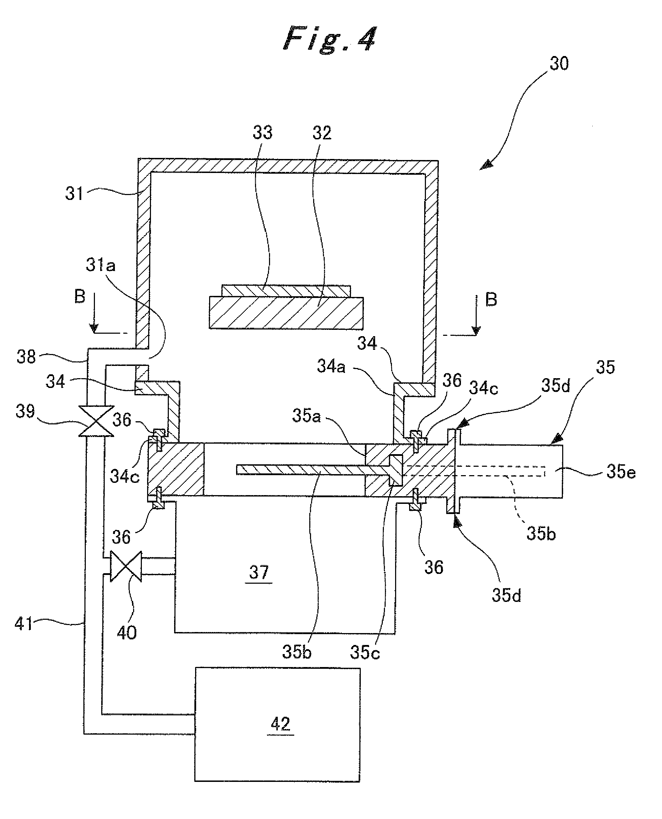

A pressure control valve is used between the vacuum chamber and the vacuum pump to control the pressure inside the vacuum chamber. Due to the increase in the diameter of a substrate, a pendulum gate valve is recently used to perform efficient gas evacuation by the turbo molecular pump. Fig. 4 shows a cross-sectional view of a conventional plasma processing apparatus having a configuration as describe above, and the outline and problems of the conventional plasma processing apparatus will be described. Note that, in the description, a plasma CVD (Chemical Vapor Deposition) apparatus will be given as an example of the processing apparatus. Moreover, illustrations of a plasma generation mechanism, a gas supplying mechanism, a substrate support structure, and the like are omitted in Fig. 4.

As shown in Fig. 4, a conventional plasma processing apparatus 30 includes a cylindrical vacuum chamber 31, a placing table 32, a pendulum gate valve 35 and a turbo molecular pump (hereinafter referred to as TMP) 37. The vacuum chamber 31 has a vacuum created therein. The placing table 32 is disposed inside the vacuum chamber 31, and a substrate 33 is placed thereon. The pendulum gate valve 35 is connected to a lower portion of the vacuum chamber 31 with a connection member 34 in between, and controls the pressure inside the vacuum chamber 31. The TMP 37 is connected to a lower portion of the pendulum gate valve 35, and evacuates the atmosphere inside the vacuum chamber 31. The connection member 34 is attached to the lower portion of the vacuum chamber 31, the pendulum gate valve 35 is attached to a flange 34c of the connection member 34 with bolts 36 inserted from above, and the TMP 37 is attached to the pendulum gate valve 35 at a flange of the TMP 37 itself with bolts 36 inserted from below. Moreover, a roughing line 38 is connected to a port 31a in a side wall of the vacuum chamber 31 to perform roughing of the inside of the vacuum chamber 31. The roughing line 38 is connected to a roughing vacuum pump 42 through a valve 39 and a gas exhaust line 41. The gas exhaust line 41 is connected to a gas exhaust port of the TMP 37 through a valve 40.

In the plasma processing apparatus 30, desired plasma processing is performed on the substrate 33 as follows. The substrate 33 is placed on the placing table 32. A desired gas is supplied into the vacuum chamber 31. The pressure inside the vacuum chamber 31 is controlled by using an unillustrated pressure control device to control an opening ratio of an opening 35a of the pendulum gate valve 35 by means of a valve body 35b. Then, plasma is generated inside the vacuum chamber 31.

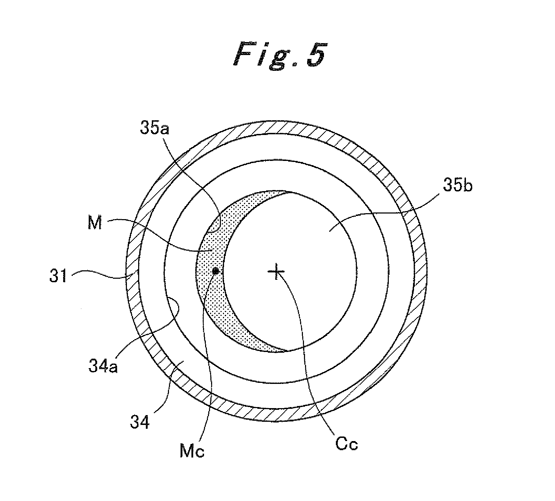

Fig. 5 shows a top view illustrating connection positions of the vacuum chamber 31, the connection member 34, and the pendulum gate valve 35. Fig. 5 is a cross-sectional view taken along the B-B line of Fig. 4 and viewed in the direction of the arrows B. As shown in Fig. 5, the connection member 34 and the pendulum gate valve 35 are disposed in such a manner that the center of an opening 34a of the connection member 34 and the center of the opening 35a of the pendulum gate valve 35 coincide with an axis center Cc of the cylindrical vacuum chamber 31. Moreover, the center of the connection portion of the TMP 37 is disposed to coincide with the axis center Cc.

Disposing the parts to have the positional relationships described above allows the atmosphere in the vacuum chamber 31 to be uniformly evacuated when the opening 35a of the pendulum gate valve 35 is fully opened. However, when the inside of the vacuum chamber 31 is to be controlled at a desired pressure, the opening 35a will not be fully opened. Generally, the pressure is controlled to be a desired value by closing part of the opening 35a with the valve body 35b to control the opening ratio of the opening 35a. Along with the movement of the circular valve body 35b relative to the circular opening 35a, an opening region M of the opening 35a in the pendulum gate valve 35 changes in a manner similar to a total solar eclipse, and thus causes unevenness in gas evacuation.

For example, when a center value of a recommended usage value of the opening ratio of the pendulum gate valve 35 is 30%, the opening region M has a crescent shape offset to one side of the opening 35a as shown in Fig. 5, and an area center Mc of the opening region M does not coincide with the axis center Cc, as a matter of course. Accordingly, uniform gas evacuation of the vacuum chamber 31 is not performed in an actual process, and uneven gas evacuation is performed instead. This may adversely affect the process.

Moreover, usage of the pendulum gate valve 35 causes the following problems due to the structure thereof.
The pendulum gate valve 35 is provided with a standby portion 35e of the valve body 35b for the maintenance of the valve body 35b. The valve body 35c is moved to the position of the standby portion 35e (see the dotted line portion in the drawing) by rotating the valve body 35b about a rotation shaft 35c. By removing the standby portion 35e at a flange 35d, the maintenance of the valve body 35b is made possible. Accordingly, it is desirable to dispose the standby portion 35e outward of a side wall of the vacuum chamber 31 from the viewpoint of performing the maintenance. However, the size (diameter) of the vacuum chamber 31 has increased due to recent increase in the diameter of the substrate. There is no need to increase the diameters of the TMP and the opening of the pendulum gate valve if a sufficient gas evacuation performance is obtained. Thus, when the center of the opening 35a of the pendulum gate valve 35 is disposed to coincide with the axis center Cc of the vacuum chamber 31, part of the standby portion 35e is disposed inward of the side wall of the vacuum chamber 31. This causes deterioration in the maintainability. If the diameters of the TMP and the opening of the pendulum gate valve are increased in accordance with the diameter of the vacuum chamber, the heights of the TMP and the pendulum gate valve are increased. Thus, the transport height of the substrate is also required to be increased. Increasing the height of the entire apparatus in accordance with the transport height should be avoided from a view point of ergonomics in handling the substrate.

Moreover, as described above, the standby portion 35e is disposed at a position accessible from the outside. However, among the bolts 36 attaching the pendulum gate valve 35 to the connection member 34, the bolts 36 on the side opposite to the standby portion 35e are located on a deeper side of the processing apparatus. Thus, the fastening and removing of those bolt 36 is difficult.

Furthermore, the pendulum gate valve 35 and the TMP 37 are disposed directly below the vacuum chamber 31. Thus, the roughing line 38 and the valve 39 have to be connected to the side wall of the vacuum chamber 31. This causes deterioration in maintainability and is not efficient in terms of effective utilization of space.

The present invention has been made in view of the problems described above, and an object thereof is to provide a gas exhaust structure and an apparatus and a method for plasma processing which improve the maintainability while allowing uniform gas evacuation.

### MEANS FOR SOLVING THE PROBLEMS

A gas exhaust structure according to a first invention for solving the above problems is a gas exhaust structure used in a processing apparatus in which a desired gas is supplied into a cylindrical vacuum chamber, a pressure inside the vacuum chamber is controlled by using a pendulum gate valve attached to a lower portion of the vacuum chamber and a vacuum pump attached to a lower portion of the pendulum gate valve, and desired processing is performed on a processing target placed in the vacuum chamber, wherein
the pendulum gate valve is attached to the vacuum chamber in such a manner that a center of an opening of the pendulum gate valve in a state where the opening is fully opened is eccentric to an axis center of the vacuum chamber in an opening direction of a valve body opening and closing the opening of the pendulum gate valve.

A gas exhaust structure according to a second invention for solving the above problems is a gas exhaust structure used in a processing apparatus in which a desired gas is supplied into a cylindrical vacuum chamber, a pressure inside the vacuum chamber is controlled by using a pendulum gate valve attached to a lower portion of the vacuum chamber and a vacuum pump attached to a lower portion of the pendulum gate valve, and desired processing is performed on a processing target placed in the vacuum chamber, wherein
the pendulum gate valve is attached to the vacuum chamber in such a manner that an area center of an opening region at a defined opening ratio of the pendulum gate valve coincides with an axis center of the vacuum chamber, the defined opening ratio is equal to a center value of a recommended usage value of the opening ratio of the pendulum gate valve.

A gas exhaust structure according to a third invention for solving the above problems is the gas exhaust structure according to the first or second invention, wherein a gas exhaust line and a valve leading to another vacuum pump are provided in a lower portion of the vacuum chamber near a lateral side of the pendulum gate valve.

An apparatus for plasma processing according to a fourth invention for solving the above problems is an apparatus for plasma processing which includes a cylindrical vacuum chamber supplied with a desired gas therein, a pendulum gate valve attached to a lower portion of the vacuum chamber, and a vacuum pump attached to a lower portion of the pendulum gate valve, and in which a pressure inside the vacuum chamber is controlled by using the pendulum gate valve and the vacuum pump, plasma of the gas is generated, and plasma processing is performed on a substrate placed in the vacuum chamber, wherein
the pendulum gate valve is attached to the vacuum chamber in such a manner that a center of an opening of the pendulum gate valve in a state where the opening is fully opened is eccentric to an axis center of the vacuum chamber in an opening direction of a valve body opening and closing the opening of the pendulum gate valve.

An apparatus for plasma processing according to a fifth invention for solving the above problems is an apparatus for plasma processing which includes a cylindrical vacuum chamber supplied with a desired gas therein, a pendulum gate valve attached to a lower portion of the vacuum chamber, and a vacuum pump attached to a lower portion of the pendulum gate valve, and in which a pressure inside the vacuum chamber is controlled by using the pendulum gate valve and the vacuum pump, plasma of the gas is generated, and plasma processing is performed on a substrate placed in the vacuum chamber, wherein
the pendulum gate valve is attached to the vacuum chamber in such a manner that an area center of an opening region at a defined opening ratio of the pendulum gate valve coincides with an axis center of the vacuum chamber, the defined opening ratio is equal to a center value of a recommended usage value of the opening ratio of the pendulum gate valve.

An apparatus for plasma processing according to a sixth invention for solving the above problems is the apparatus for plasma processing according to the fourth or fifth invention, wherein a gas exhaust line and a valve leading to another vacuum pump are provided in a lower portion of the vacuum chamber near a lateral side of the pendulum gate valve.

A method for plasma processing according to a seventh invention for solving the above problems is a method for plasma processing using the apparatus for plasma processing according to any one of the fourth to sixth inventions, the method comprising:
supplying gas into the vacuum chamber;
controlling the pressure inside the vacuum chamber by use of the pendulum gate valve and the vacuum pump;
generating the plasma of the gas; and
performing the plasma processing on the substrate placed in the vacuum chamber.

### EFFECTS OF THE INVENTION

In the first invention, the pendulum gate valve is attached to the vacuum chamber in such an eccentric manner that the center of the opening of the pendulum gate valve in the state where the opening is fully opened is eccentric to the axis center of the vacuum chamber in the opening direction of the valve body. Thus, the flow of gas evacuation in processing is uniform compared to a conventional gas exhaust structure, i.e. the case where the parts are disposed in such a manner that the axis center of the vacuum chamber coincides with the center of the opening of the pendulum gate valve in the state where the opening is fully opened. Moreover, since the pendulum gate valve is eccentrically attached to the vacuum chamber, a standby portion of the pendulum gate valve which is to be removed in maintenance and bolts attaching the pendulum gate valve to the vacuum chamber are disposed more outward than those of the conventional gas exhaust structure. Thus, the maintenance is easy.

In the second invention, the pendulum gate valve is attached to the vacuum chamber in such an eccentric manner that the area center of the opening region at a defined opening ratio of the pendulum gate valve coincides with the axis center of the vacuum chamber. The defined opening ratio is equal to the center value of the recommended usage value of an opening ratio of the pendulum gate valve. Thus, the flow of gas evacuation in processing is uniform compared to the conventional gas exhaust structure. Moreover, since the pendulum gate valve is eccentrically attached to the vacuum chamber, a standby portion of the pendulum gate valve which is to be removed in maintenance and bolts attaching the pendulum gate valve to the vacuum chamber are disposed more outward than those of the conventional gas exhaust structure. Thus, the maintenance is easy.

In the third invention, the gas exhaust line leading to the other vacuum pump is provided in the lower portion of the vacuum chamber near the lateral side of the pendulum gate valve. Thus, the space inside the apparatus for processing is effectively used. In addition, access to the gas exhaust line is easy compared to the conventional gas exhaust structure, and thus the maintainability is improved.

In the fourth to seventh inventions, by applying the gas exhaust structure of any one of the first to third inventions described above to the apparatus and the method for plasma processing, the flow of gas evacuation is made more uniform in a process performed in a degree of vacuum in which the pressure is relatively high, such for example as plasma cleaning. Thus, the plasma cleaning can be performed uniformly without unevenness. Hence, excessive use of gas is reduced, and damage on an inner surface of the chamber by plasma is also reduced.

### BRIEF DESCRIPTION OF THE DRAWINGS

[Fig. 1] Fig. 1 is a cross-sectional view showing an example of an embodiment of a gas exhaust structure of the present invention, and illustrates the gas exhaust structure in a plasma CVD apparatus.
[Fig. 2] Fig. 2 is a cross-sectional view taken along the A-A line of Fig. 1 and viewed in the direction of the arrows A.
[Fig. 3] Fig. 3 is a perspective view showing a modified example of a connection member shown in Fig. 1.
[Fig. 4] Fig. 4 is a cross-sectional view of a conventional plasma processing apparatus.
[Fig. 5] Fig. 5 is a cross-sectional view taken along the B-B line of Fig. 4 and viewed in the direction of the arrows B.

### EXPLANATION OF THE REFERENCE NUMERALS

- 10: PLASMA CVD APPARATUS
- 11: VACUUM CHAMBER
- 12: PLACING TABLE
- 13: SUBSTRATE
- 14, 24: CONNECTION MEMBER
- 15: PENDULUM GATE VALVE
- 16: BOLT
- 17: TURBO MOLECULAR PUMP (TMP)
- 18: ROUGHING LINE
- 19, 20: VALVE
- 21: GAS EXHAUST LINE
- 22: VACUUM PUMP

### BEST MODE FOR CARRYING OUT THE INVENTION

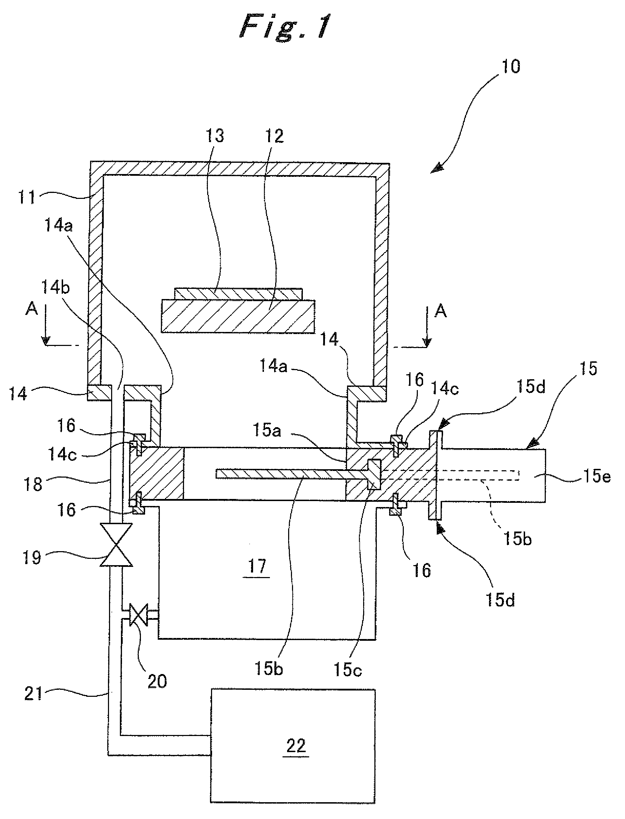

An example of an embodiment of a gas exhaust structure and an apparatus and a method for plasma processing of the present invention will be described with reference to Figs. 1 to 3. Note that, a plasma CVD apparatus is given as an example in this description. However, the present invention is applicable not only to the plasma CVD apparatus but also to a plasma etching apparatus. In addition, the present invention is applicable to other processing apparatuses which require uniform gas evacuation to be performed in a vacuum chamber.

### (Embodiment 1)

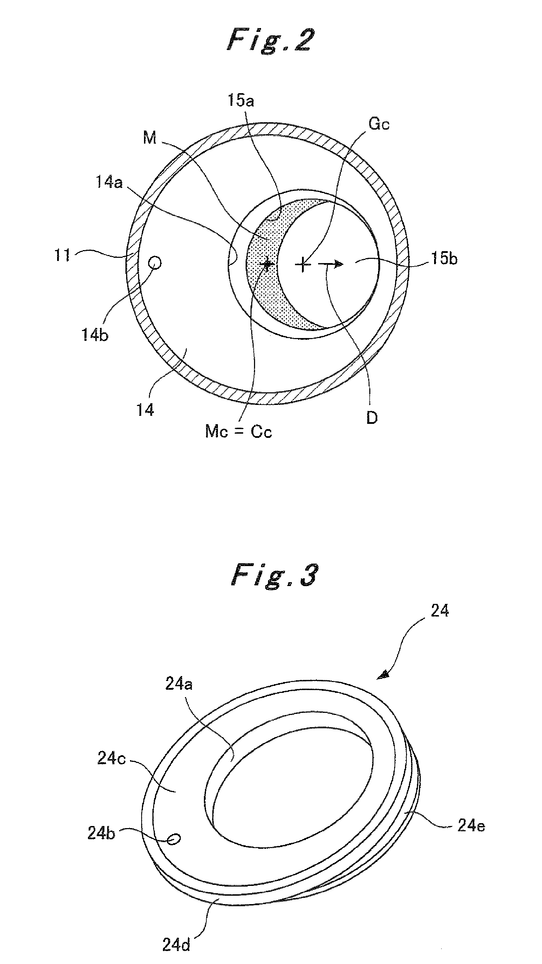

Figs. 1 and 2 are cross-sectional views showing an example of the embodiment of the gas exhaust structure of the present invention. Fig. 1 illustrates the gas exhaust structure in the plasma CVD apparatus. Fig. 2 is a cross-sectional view taken along the A-A line of Fig. 1 and viewed in the direction of the arrows A. Note that, illustrations of a plasma generation mechanism, a gas supplying mechanism, and the like are omitted in Figs. 1 and 2.

As shown in Fig. 1, a plasma processing apparatus 10 of the embodiment includes a cylindrical vacuum chamber 11, a placing table 12, a pendulum gate valve 15, and a TMP (turbo molecular pump) 17. A desired gas is supplied into the vacuum chamber 11, and the pressure inside the vacuum chamber 11 is controlled. The placing table 12 is disposed inside the vacuum chamber 11, and a substrate (processing target) 13 to be subjected to desired processing is placed thereon. The pendulum gate valve 15 is attached to a lower portion of the vacuum chamber 11 with a connection member 14 in between, and controls the pressure inside the vacuum chamber 11. The TMP 17 is attached to a lower portion of the pendulum gate valve 15, and evacuates the atmosphere inside the vacuum chamber 11. Note that, the placing table 12 has a cylindrical shape, and has a structure in which a lower portion of the placing table 12 is surely supported on a side wall of the vacuum chamber 11. However, an illustration of this structure is omitted in this drawing. Moreover, the connection member 14 is attached to the lower portion of the vacuum chamber 11, the pendulum gate valve 15 is attached to a flange 14c of the connection member 14 with bolts 16 inserted from above, and the TMP 17 is attached to the pendulum gate valve 15 at a flange of the TMP 17 itself with bolts 16 inserted from below.

In the embodiment, the pendulum gate valve 15 is eccentrically attached to the vacuum chamber 11. Specifically, as shown in Fig. 2, the pendulum gate valve 15 is disposed in such a way that an axis center Cc of the cylindrical vacuum chamber 11 coincides with an area center Mc of an opening region M of the pendulum gate valve 15. The opening region M changes in accordance with an opening ratio of the pendulum gate valve 15 as a matter of course. In the embodiment, the area center Mc of the opening region M is obtained on the basis of an opening region M at an opening ratio of 30% (a defined opening ratio), which is a center value of a recommended usage value range (10% to 50%) of the opening ratio of the pendulum gate valve 32. Then, the pendulum gate valve 15 is eccentrically disposed in such a way that the axis center Cc and the area center Mc coincide with each other. Accordingly, a center Gc in a state where an opening 15a of the pendulum gate valve 15 is fully opened is eccentric to the axis center Cc of the vacuum chamber 11 in an opening direction D of a valve body 15b opening and closing the opening 15a. Note that, the center of the connection portion of the TMP 17 is disposed to coincide with the center of the opening 15a of the pendulum gate valve 15.

If the parts are disposed to have the positional relationships described above, the atmosphere inside the vacuum chamber 31 is evacuated uniformly when the opening ratio of the pendulum gate valve 15 is controlled to be around 30% and the inside of the vacuum chamber 11 is controlled to a desired pressure. When the opening ratio is not around 30% and the inside of the vacuum chamber 11 is controlled to a desire pressure, the gas evacuation is slightly less uniform than when the opening ratio is 30%. Nonetheless, even in such case, the gas evacuation can be made more uniform than the conventional case.

These effects are seen remarkably in processing performed in a degree of vacuum in which a pressure is relatively high. For example, plasma cleaning in a plasma CVD apparatus is performed in a degree of vacuum in which a pressure is a relatively high. Conventionally, the plasma cleaning has been performed unevenly, and there have been a case where excessive gas is consumed to perform certain cleaning and a case where excessive cleaning is performed on some portion thereby causing plasma damage. On the contrary, in the embodiment, uniform plasma cleaning is performed on the vacuum chamber 11 and the placing table 12 by using the gas exhaust structure described above. As a result, damage due to excessive use of gas and plasma is reduced. Hence, it is possible to reduce the frequency of maintenance and extend the lives of the parts.

Moreover, since the pendulum gate valve 15 is eccentrically attached, an opening 14a of the connection member 14 is also eccentrically provided, and the direction of this eccentricity coincides with the opening direction D of the valve body 15b. As a result, a space is made in a portion opposite to the side in which the opening 14a is eccentrically provided. This allows a port 14b for a roughing gas exhaust line 18 to be provided in the lower portion of the vacuum chamber 11 near the lateral side of the pendulum gate valve 15, and allows the roughing gas exhaust line 18, a valve 19, and the like to be disposed directly below the vacuum chamber 11 even if the port is in a side wall of the vacuum chamber 11. In the embodiment, to perform roughing of the inside of the vacuum chamber 11, the roughing line 18 is connected not to the side wall of the vacuum chamber 11 but to the port 14b in a bottom portion of the vacuum chamber 11, and is connected to a roughing vacuum pump 22 through the valve 19 and a gas exhaust line 21. In addition, the gas exhaust line 21 is connected to a gas exhaust port of the TMP 17 through a valve 20. As described above, the roughing line 18, the valve 19, and the like can be disposed directly below the vacuum chamber 11, and be disposed efficiently together with the TMP 17 and the like in an internal space of the processing apparatus.

Furthermore, since the pendulum gate valve 15 is eccentrically connected, a standby portion 15e of the valve body 15b is disposed more outward of the side wall of the vacuum chamber 11 than the conventional processing apparatus. Accordingly, the position of a flange 15d is located more outward, and the standby portion 15e can be easily accessed. Accordingly, the maintenance of the valve body 15b can be performed by rotating the valve body 15b about a rotation shaft 15c to move the valve body 15b to the position of the standby portion 15e. Thus, the maintainability of the pendulum gate valve 15 can be also improved.

The eccentric connection of the pendulum gate valve 15 causes the bolts 16 on the side opposite to the standby portion 15e to be disposed on a closer side than those in the conventional processing apparatus. Thus, difficulty in fastening and removing the bolts 16 can be also reduced.

Note that, in Figs. 1 and 2, the connection member 14 has a simple structure in which the opening 14a is eccentrically provided in a circular-plate-shaped member. However, a configuration like a connection member 24 shown in Fig. 3 may be employed to perform gas evacuation more smoothly. Specifically, the connection member 24 includes an eccentric opening 24a and a roughing line port 24b, as similar to the connection member 14. However, an inclined portion 24c is formed from an opening part in an upper portion of the connection member 24 to the opening 24a, and has such a structure that gas is smoothly evacuated to the opening 24a. Note that, in the connection member 24, an upper flange 24d is connected to the vacuum chamber 11, and a lower flange 24e is connected to the pendulum gate valve 15.

### INDUSTRIAL APPLICABILITY

The present invention is preferably applied to an apparatus and a method for plasma processing such as plasma CVD and plasma etching used to manufacture a semiconductor device. However, the present invention is not limited to the apparatus manufacturing a semiconductor device, and can be also applied to an apparatus manufacturing other products, as long as the apparatus is one which has a gas exhaust port in a lower portion of a vacuum chamber.

## Claims

1. A gas exhaust structure used in a processing apparatus in which a desired gas is supplied into a cylindrical vacuum chamber, a pressure inside the vacuum chamber is controlled by using a pendulum gate valve attached to a lower portion of the vacuum chamber and a vacuum pump attached to a lower portion of the pendulum gate valve, and desired processing is performed on a processing target placed in the vacuum chamber, wherein
the pendulum gate valve is attached to the vacuum chamber in such a manner that a center of an opening of the pendulum gate valve in a state where the opening is fully opened is eccentric to an axis center of the vacuum chamber in an opening direction of a valve body opening and closing the opening of the pendulum gate valve.

2. A gas exhaust structure used in a processing apparatus in which a desired gas is supplied into a cylindrical vacuum chamber, a pressure inside the vacuum chamber is controlled by using a pendulum gate valve attached to a lower portion of the vacuum chamber and a vacuum pump attached to a lower portion of the pendulum gate valve, and desired processing is performed on a processing target placed in the vacuum chamber, wherein
the pendulum gate valve is attached to the vacuum chamber in such a manner that an area center of an opening region at a defined opening ratio of the pendulum gate valve coincides with an axis center of the vacuum chamber, the defined opening ratio is equal to a center value of a recommended usage value of the opening ratio of the pendulum gate value.

3. The gas exhaust structure according to claim 1 or 2, wherein a gas exhaust line and a valve leading to another vacuum pump are provided in a lower portion of the vacuum chamber near a lateral side of the pendulum gate valve.

4. An apparatus for plasma processing which includes a cylindrical vacuum chamber supplied with a desired gas therein, a pendulum gate valve attached to a lower portion of the vacuum chamber, and a vacuum pump attached to a lower portion of the pendulum gate valve, and in which a pressure inside the vacuum chamber is controlled by using the pendulum gate valve and the vacuum pump, plasma of the gas is generated, and plasma processing is performed on a substrate placed in the vacuum chamber, wherein
the pendulum gate valve is attached to the vacuum chamber in such a manner that a center of an opening of the pendulum gate valve in a state where the opening is fully opened is eccentric to an axis center of the vacuum chamber in an opening direction of a valve body opening and closing the opening of the pendulum gate valve.

5. An apparatus for plasma processing which includes a cylindrical vacuum chamber supplied with a desired gas therein, a pendulum gate valve attached to a lower portion of the vacuum chamber, and a vacuum pump attached to a lower portion of the pendulum gate valve, and in which a pressure inside the vacuum chamber is controlled by using the pendulum gate valve and the vacuum pump, plasma of the gas is generated, and plasma processing is performed on a substrate placed in the vacuum chamber, wherein
the pendulum gate valve is attached to the vacuum chamber in such a manner that an area center of an opening region at a defined opening ratio of the pendulum gate valve coincides with an axis center of the vacuum chamber, the defined opening ratio is equal to a center value of a recommended usage value of the opening ratio of the pendulum gate valve.

6. The apparatus for plasma processing according to claim 4 or 5, wherein a gas exhaust line and a valve leading to another vacuum pump are provided in a lower portion of the vacuum chamber near a lateral side of the pendulum gate valve.

7. A method for plasma processing using the apparatus for plasma processing according to any one of claims 4 to 6, the method comprising:
supplying gas into the vacuum chamber;
controlling the pressure inside the vacuum chamber by use of the pendulum gate valve and the vacuum pump;
generating the plasma of the gas; and
performing the plasma processing on the substrate placed in the vacuum chamber.
